# EUROPEAN PATENT APPLICATION

(11) **EP 4 243 090 A1**
(43) Date of publication of application: **13.09.2023**
(21) Application number: 22160501.7
(22) Date of filing: 07.03.2022
(51) Int. Cl.: H01L 31/0304, H01L 31/0687, H01L 31/18

(54) **FOUR JUNCTION METAMORPHIC MULTIJUNCTION SOLAR CELLS FOR SPACE APPLICATIONS**

(71) Applicant: SolAero, Albuquerque, NM 87123 (US)
(72) Inventor: DERKACS, Daniel, Albuquerque, 87123 (US); MCGLYNN, Daniel, Albuquerque, 87123 (US)
(74) Representative: Rummler, Felix

(57) **Abstract**

A method of fabricating four junction solar cell wherein the selection of the composition of the subcells and their band gaps maximizes the efficiency at high temperature (in the range of 50 to 100 degrees Centigrade) in deployment in space at a specific predetermined time after initial deployment (referred to as the beginning of life or BOL), such predetermined time being referred to as the end-of-life (EOL), and being at least five years after the BOL, such selection being designed not to maximize the efficiency at BOL but to increase the solar cell efficiency at the EOL while disregarding the solar cell efficiency achieved at the BOL, such that the solar cell efficiency at the BOL is less than the solar cell efficiency at the BOL that would be achieved if the selection were designed to maximize the solar cell efficiency at the BOL.

## Description

### Field of the Invention

The present disclosure relates to multijunction solar cells and the fabrication of multijunction solar cells, and more particularly the design and specification of a lattice mismatched multijunction solar cells adapted for specific space missions and high temperature "end of life" performance objectives.

### Description of the Related Art

Solar power from photovoltaic cells, also called solar cells, has been predominantly provided by silicon semiconductor technology. In the past several years, however, high-volume manufacturing of III-V compound semiconductor multijunction solar cells for space applications has accelerated the development of such technology. Compared to silicon, III-V compound semiconductor multijunction devices have greater energy conversion efficiencies and are generally more radiation resistance, although they tend to be more complex to properly specify and manufacture. Typical commercial III-V compound semiconductor multijunction solar cells have energy efficiencies that exceed 29.5% under one sun, air mass 0 (AM0) illumination, whereas even the most efficient silicon technologies generally reach only about 18% efficiency under comparable conditions. The higher conversion efficiency of III-V compound semiconductor solar cells compared to silicon solar cells is in part based on the ability to achieve spectral splitting of the incident radiation through the use of a plurality of series connected photovoltaic regions with different band gap energies, and accumulating the voltage at a given current from each of the regions.

In satellite and other space related applications, the size, mass and cost of a satellite power system are dependent on the power and energy conversion efficiency of the solar cells used. Putting it another way, the size of the payload and the availability of on-board services are proportional to the amount of power provided. Thus, as payloads use increasing amounts of power as they become more sophisticated, and missions and applications anticipated for five, ten, twenty or more years, the power-to-weight (W/kg) and power-to-area (W/m²) ratios of the solar cell array and the lifetime efficiency of a solar cell becomes increasingly more important. There is increasing interest not only the amount of power provided per gram of weight and spatial area of the solar cell, not only at initial deployment but over the entire service life of the satellite system, or in terms of a design specification, the amount of residual power provided at the specified "end of life" (EOL), which is affected by the radiation exposure of the solar cell over time in the particular space environment of the solar cell array, the period of the EOL being different for different missions and applications.

Typical III-V compound semiconductor solar cells are fabricated on a semiconductor wafer in vertical, multijunction structures or stacked sequence of solar subcells, each subcell formed with appropriate semiconductor layers and including a p-n photoactive junction. Each subcell is designed to convert photons over different spectral or wavelength bands to electrical current. After the sunlight impinges on the front of the solar cell, and photons pass through the subcells, with each subcell being designed for photons in a specific wavelength band. After passing through a subcell, the photons that are not absorbed and converted to electrical energy propagate to the next subcells, where such photons are intended to be captured and converted to electrical energy.

The individual solar cells or wafers are then disposed in horizontal arrays, with the individual solar cells connected together in an electrical series and/or parallel circuit. The shape and structure of an array, as well as the number of cells it contains, are determined in part by the desired output voltage and current needed by the payload or subcomponents of the payload, the amount of electrical storage capacity (batteries) on the spacecraft, and the power demands of the payloads during different orbital configurations.

A solar cell designed for use in a space vehicle (such as a satellite, space station, or an interplanetary mission vehicle), has a sequence of subcells with compositions and band gaps which have been optimized to achieve maximum energy conversion efficiency for the AM0 solar spectrum in space. The AM0 solar spectrum in space is notably different from the AM1.5 solar spectrum at the surface of the earth, and accordingly terrestrial solar cells are designed with subcell band gaps optimized for the AM1.5 solar spectrum.

There are substantially more rigorous qualification and acceptance testing protocols used in the manufacture of space solar cells compared to terrestrial cells, to ensure that space solar cells can operate satisfactorily at the wide range of temperatures and temperature cycles encountered in space. These testing protocols include (i) high-temperature thermal vacuum bake-out; (ii) thermal cycling in vacuum (TVAC) or ambient pressure nitrogen atmosphere (APTC); and in some applications (iii) exposure to radiation equivalent to that which would be experienced in the space mission, and measuring the current and voltage produced by the cell and deriving cell performance data.

As used in this disclosure and claims, the term "space-qualified" shall mean that the electronic component (i.e., in this disclosure, the solar cell) provides satisfactory operation under the high temperature and thermal cycling test protocols. The exemplary conditions for vacuum bake-out testing include exposure to a temperature of +100 °C to +135 °C (e.g., about +100 °C, +110 °C, +120 °C, +125 °C, +135 °C) for 2 hours to 24 hours, 48 hours, 72 hours, or 96 hours; and exemplary conditions for TVAC and/or APTC testing that include cycling between temperature extremes of -180 °C (e.g., about -180 °C, -175 °C, -170 °C, -165 °C, - 150 °C, -140 °C, -128 °C, -110 °C, -100 °C, -75 °C, or -70 °C) to +145 °C (e.g., about +70 °C, +80 °C, +90 °C, +100 °C, +110 °C, +120 °C, +130 °C, +135 °C, or +145 °C) for 600 to 32,000 cycles (e.g., about 600, 700, 1500, 2000, 4000, 5000, 7500, 22000, 25000, or 32000 cycles), and in some space missions up to +180° C. See, for example, Fatemi et al., "Qualification and Production of Emcore ZTJ Solar Panels for Space Missions," Photovoltaic Specialists Conference (PVSC), 2013 IEEE 39th (DOI: 10. 1109/PVSC 2013 6745052). Such rigorous testing and qualifications are not generally applicable to terrestrial solar cells and solar cell arrays.

Conventionally, such measurements are made for the AM0 spectrum for "one-sun" illumination, but for PV systems which use optical concentration elements, such measurements may be made under concentrations such as 2×, 100×, or 1000× or more.

The space solar cells and arrays experience a variety of complex environments in space missions, including the vastly different illumination levels and temperatures seen during normal earth orbiting missions, as well as even more challenging environments for deep space missions, operating at different distances from the sun, such as at 0.7, 1.0 and 3.0AU (AU meaning astronomical units). The photovoltaic arrays also endure anomalous events from space environmental conditions, and unforeseen environmental interactions during exploration missions. Hence, electron and proton radiation exposure, collisions with space debris, and/or normal aging in the photovoltaic array and other systems could cause suboptimal operating conditions that degrade the overall power system performance, and may result in failures of one or more solar cells or array strings and consequent loss of power.

A further distinctive difference between space solar cell arrays and terrestrial solar cell arrays is that a space solar cell array utilizes welding and not soldering to provide robust electrical interconnections between the solar cells, while terrestrial solar cell arrays typically utilize solder for electrical interconnections. Welding is required in space solar cell arrays to provide the very robust electrical connections that can withstand the wide temperature ranges and temperature cycles encountered in space such as from -175° C to +180° C. In contrast, solder joints are typically sufficient to survive the rather narrow temperature ranges (e.g., about -40° C to about +50° C) encountered with terrestrial solar cell arrays.

A further distinctive difference between space solar cell arrays and terrestrial solar cell arrays is that a space solar cell array utilizes silver-plated metal material for interconnection members, while terrestrial solar cells typically utilize copper wire for interconnects. In some embodiments, the interconnection member can be, for example, a metal plate. Useful metals include, for example, molybdenum; a nickel-cobalt ferrous alloy material designed to be compatible with the thermal expansion characteristics of borosilicate glass such as that available under the trade designation KOVAR from Carpenter Technology Corporation; a nickel iron alloy material having a uniquely low coefficient of thermal expansion available under the trade designation Invar, FeNi36, or 64FeNi; or the like.

An additional distinctive difference between space solar cell arrays and terrestrial solar cell arrays is that space solar cell arrays typically utilize an aluminum honeycomb panel for a substrate or mounting platform. In some embodiments, the aluminum honeycomb panel may include a carbon composite face sheet adjoining the solar cell array. In some embodiments, the face sheet may have a coefficient of thermal expansion (CTE) that substantially matches the CTE of the bottom germanium (Ge) layer of the solar cell that is attached to the face sheet. Substantially matching the CTE of the face sheet with the CTE of the Ge layer of the solar cell can enable the array to withstand the wide temperature ranges encountered in space without the solar cells cracking, delaminating, or experiencing other defects. Such precautions are generally unnecessary in terrestrial applications.

Thus, a further distinctive difference of a space solar cell from a terrestrial solar cell is that the space solar cell must include a cover glass over the semiconductor device to provide radiation resistant shielding from particles in the space environment which could damage the semiconductor material. The cover glass is typically a ceria doped borosilicate glass which is typically from three to six mils in thickness and attached by a transparent adhesive to the solar cell.

In summary, it is evident that the differences in design, materials, and configurations between a space-qualified III-V compound semiconductor solar cell and subassemblies and arrays of such solar cells, on the one hand, and silicon solar cells or other photovoltaic devices used in terrestrial applications, on the other hand, are so substantial that prior teachings associated with silicon or other terrestrial photovoltaic system are simply unsuitable and have no applicability to the design configuration of space-qualified solar cells and arrays. Indeed, the design and configuration of components adapted for terrestrial use with its modest temperature ranges and cycle times often teach away from the highly demanding design requirements for space-qualified solar cells and arrays and their associated components.

The assembly of individual solar cells together with electrical interconnects and the cover glass form a so-called "CIC" (Cell-Interconnected-Cover glass) assembly, which are then typically electrically connected to form an array of series-connected solar cells. The solar cells used in many arrays often have a substantial size; for example, in the case of the single standard substantially "square" solar cell trimmed from a 100 mm wafer with cropped corners, the solar cell can have a side length of seven cm or more.

The radiation hardness of a solar cell is defined as how well the cell performs after exposure to the electron or proton particle radiation which is a characteristic of the space environment. A standard metric is the ratio of the end of life performance (or efficiency) divided by the beginning of life performance (EOL/BOL) of the solar cell. The EOL performance is the cell performance parameter after exposure of that test solar cell to a given fluence of electrons or protons (which may be different for different space missions or orbits). The BOL performance is the performance parameter prior to exposure to the particle radiation.

Charged particles in space could lead to damage to solar cell structures, and in some cases, dangerously high voltage being established across individual devices or conductors in the solar array. These large voltages can lead to catastrophic electrostatic discharging (ESD) events. Traditionally for ESD protection the backside of a solar array may be painted with a conductive coating layer to ground the array to the space plasma, or one may use a honeycomb patterned metal panel which mounts the solar cells and incidentally protects the solar cells from backside radiation. Furthermore, the front side of the solar array may provide a conductive coating or adhesive to the periphery of the cover glass to ground the top surface of the cover glass.

The radiation hardness of the semiconductor material of the solar cell itself is primarily dependent on a solar cell's minority carrier diffusion length (Lₘᵢₙ) in the base region of the solar cell (the term "base" region referring to the p-type base semiconductor region disposed directly adjacent to an n-type "emitter" semiconductor region, the boundary of which establishes the p-n photovoltaic junction). The less degraded the parameter Lₘᵢₙ is after exposure to particle radiation, the less the solar cell performance will be reduced. A number of strategies have been used to either improve Lₘᵢₙ, or make the solar cell less sensitive to Lₘᵢₙ reductions. Improving Lₘᵢₙ has largely involved including a gradation in dopant elements in the semiconductor base layer of the subcells so as to create an electric field to direct minority carriers to the junction of the subcell, thereby effectively increasing Lₘᵢₙ. The effectively longer Lₘᵢₙ will improve the cell performance, even after the particle radiation exposure. Making the cell less sensitive to Lₘᵢₙ reductions has involved increasing the optical absorption of the base layer such that thinner layers of the base can be used to absorb the same amount of incoming optical radiation.

Another consideration in connection with the manufacture of space solar cell arrays is that conventionally, solar cells have been arranged on a support and interconnected using a substantial amount of manual labor. For example, first individual CICs are produced with each interconnect individually welded to the solar cell, and each cover glass individually mounted. Then, these CICs are connected in series to form strings, generally in a substantially manual manner, including the welding steps from CIC to CIC. Then, these strings are applied to a panel substrate and electrically interconnected in a process that includes the application of adhesive, wiring, etc. All of this has traditionally been carried out in a manual and substantially artisanal manner.

The energy conversion efficiency of multijunction solar cells is affected by such factors as the number of subcells, the thickness of each subcell, the composition and doping of each active layer in a subcell, and the consequential band structure, electron energy levels, conduction, and absorption of each subcell, as well as the effect of its exposure to radiation in the ambient environment over time. The identification and specification of such design parameters is a non-trivial engineering undertaking, and would vary depending upon the specific space mission and customer design requirements. Since the power output is a function of both the voltage and the current produced by a subcell, a simplistic view may seek to maximize both parameters in a subcell by increasing a constituent element, or the doping level, to achieve that effect. However, in reality, changing a material parameter that increases the voltage may result in a decrease in current, and therefore a lower power output. Such material design parameters are interdependent and interact in complex and often unpredictable ways, and for that reason are not "result effective" variables that those skilled in the art confronted with complex design specifications and practical operational considerations can easily adjust to optimize performance.

In that connection, it should be noted that there is no strict definition of what is understood to mean two adjacent layers are "lattice matched" or "lattice mismatched". For purposes in this disclosure, "lattice mismatched" refers to two adjacently disposed materials or layers (with thicknesses of greater than 100 nm) having in-plane lattice constants of the materials in their fully relaxed state differing from one another by more than 0.1% in lattice constant. (Applicant notes that this definition is considerably more stringent than that proposed, for example, in U.S. Patent No. 8,962,993, which suggests more than 0.6% lattice constant difference as defining "lattice mismatched" layers).

The conventional wisdom for many years has been that in a monolithic tandem solar cell, "... the desired optical transparency and current conductivity between the top and bottom cells... would be best achieved by lattice matching the top cell material to the bottom cell material. Mismatches in the lattice constants create defects or dislocations in the crystal lattice where recombination centers can occur to cause the loss of photogenerated minority carriers, thus significantly degrading the photovoltaic quality of the device. More specifically, such effects will decrease the open circuit voltage (V_{oc}), short circuit current (J_{sc}), and fill factor (FF), which represents the relationship or balance between current and voltage for effective output" (Jerry M. Olson, U.S. Patent No. 4,667,059, "Current and Lattice Matched Tandem Solar Cell").

As progress has been made toward higher efficiency multijunction solar cells with four or more subcells, nevertheless, "it is conventionally assumed that substantially lattice-matched designs are desirable because they have proven reliability and because they use less semiconductor material than metamorphic solar cells, which require relatively thick buffer layers to accommodate differences in the lattice constants of the various materials" (Rebecca Elizabeth Jones - Albertus et al., U.S. Patent No. 8,962,993).

The present disclosure proposes design features for multijunction solar cells which departs from such conventional wisdom concerning the lattice matching of solar subcells for increasing the efficiency of the multijunction solar cell in converting solar energy (or photons) to electrical energy and optimizing such efficiency at the "end-of-life" period.

### SUMMARY OF THE DISCLOSURE

### Objects of the Disclosure

It is an object of the present disclosure to provide increased photoconversion efficiency in a metamorphic multijunction solar cell for space applications over the operational life of the photovoltaic power system.

It is another object of the present disclosure to provide in a metamorphic multijunction solar cell in which the selection of the composition of the subcells and their band gaps maximizes the efficiency of the solar cell at a predetermined high temperature (in the range of 40 to 100 degrees Centigrade) in deployment in space at AM0 at a predetermined time after the initial deployment, such time being at least five years.

It is another object of the present invention to provide a lattice matched or lattice mismatched four junction solar cell in which the current through the bottom subcell is intentionally designed to be substantially greater than current through the top three subcells when measured at the "beginning-of-life" or time of initial deployment.

Some implementations of the present disclosure may incorporate or implement fewer of the aspects and features noted in the foregoing objects.

### Features of the Disclosure

Briefly, and in general terms, the present disclosure also provides a multijunction solar cell comprising: a germanium growth substrate; a first solar subcell formed over or in the growth substrate; a graded interlayer formed over the growth substrate; a first middle solar subcell disposed over a lattice mismatched with respect to the growth substrate and having a band gap in the range of 1.2 to 1.35 eV; a second middle solar subcell disposed over the first middle solar subcell and having a band gap in the range of approximately 1.61 to 1.8 eV; an upper solar subcell disposed over the second middle subcell and having an aluminum content in excess of 20% by mole fraction, a band gap in the range of 1.95 to 2.20 eV; wherein the graded interlayer is compositionally graded to lattice match the growth substrate on one side and the first middle solar subcell on the other side, and is composed of the As, P, N, Sb based III-V compound semiconductors subject to the constraints of having the in-plane lattice parameter throughout its thickness being greater than or equal to that of the growth substrate; and wherein the selection of the composition of the subcells and their band gaps maximizes the efficiency at high temperature (in the range of 50 to 100 degrees Centigrade) in deployment in space at a specific predetermined time after initial deployment (referred to as the beginning of life or BOL), such predetermined time being referred to as the end-of-life (EOL), and being at least five years after the BOL, such selection being designed not to maximize the efficiency at BOL but to increase the solar cell efficiency at the EOL while disregarding the solar cell efficiency achieved at the BOL, such that the solar cell efficiency designed at the BOL is less than the solar cell efficiency at the BOL that would be achieved if the selection were designed to maximize the solar cell efficiency at the BOL.

Although the above description describes a "first middle solar subcell" and a "second middle solar subcell" grown over the growth substrate, an alternative description of identifying the upper or top solar subcell (closest to the light source) as the "first" solar subcell, and the tandem stack of solar cells below the upper on top solar subcell as the "second", and "third" solar subcells, etc., is sometimes used in this specification. The context using the alternative description should moreover be clear with the identification of such "first" solar subcell in that description as the "upper first" solar subcell.

In another aspect, the present disclosure provides a method of fabricating a four junction solar cell for deployment in space in AM0 spectra in a specific earth orbit characterized by a predetermined temperature and radiation environment comprising: providing a defined predetermined time and defined temperature and radiation environment comprising: providing a defined predetermined time and defined temperature in the range of 40° to 100° Centigrade after initial deployment, such time being at least one year and in the range of one to twenty-five years; determining the amount of radiation experienced by the solar cell after deployment at the predetermined time in the specific earth orbit after deployment; simulating the effect of such radiation and temperature on a plurality of upper first, second and third solar subcell candidates for implementation by a computer program; and identifying the composition and band gaps of the upper first, second and third subcells that maximizes the efficiency of the solar cell at that predetermined time so that the selection of the composition of the subcells and their band gaps maximizes the efficiency at high temperature (in the range of 50 to 100 degrees Centigrade) in deployment in space at a specific predetermined time after initial deployment (referred to as the beginning of life or BOL), such predetermined time being referred to as the end-of-life (EOL), and being at least five years after the BOL, such selection being designed not to maximize the efficiency at the BOL but to increase the solar cell efficiency at the EOL while disregarding the solar cell efficiency achieved at the BOL that would be achieved if the selection were designed to maximize the solar cell efficiency at the BOL.

In some embodiments, there further comprises fabricating one or more four-junction test solar cells in accordance with the identified composition and band gaps of the upper first, second and third subcells; performing one or more optical or electrical tests on the fabricated one or more four-junction test solar cells; based on results of the tests, determining one or more characteristics of at least one of the upper first, second or third subcells to be modified in subsequent fabrication of four-junction solar cells, including the amount of aluminum in the top subcell, and the band gap, doping level and profile, and thickness of each of the subcell layers; and fabricating a further four-junction solar cell in accordance with the modified properities of at least one of the upper first, second or third subcells to optimize the efficiency at the predetermined time in the specific earth orbit.

In some embodiments, the step of fabricating one or more test solar cells utilizes an MOCVD reactor which accommodates five or more semiconductor wafers, which are disposed at different positions on a platter, and the step of performing one or more tests include making an electroluminescence measurement on each of the semiconductor wafers.

In some embodiments, the electrical tests includes measuring the open circuit voltage, the short circuit current, and the fill factor associated with the test solar cell subsequent to fabrication on each respective semiconductor wafer disposed on the platter.

In some embodiments, the characteristics to be modified in each of the subcells as a result of the tests include interdependent variables including the thickness of the layers, the doping, and the doping profile of each respective layer.

In some embodiments, the upper first subcell is composed of indium gallium aluminum phosphide, with the amount of aluminum being at least 20%, 25%, or 30% by mole fraction.

In some embodiments, the determination of the amount of radiation at a predetermined time is 1 MeV electron equivalent fluence of 1 × 10¹⁵ electrons/cm².

In some embodiments, the determination of the amount of radiation at a predetermined time is 1 MeV electron equivalent fluence is between 5 × 10¹⁴ electrons/cm² and 5 × 10¹⁵ electrons/cm².

In some embodiments, the determination of the specific earth orbit is either a low earth orbit (LEO) or geosynchronous earth orbit (GEO).

In some embodiments, the step of identifying the composition of subcells utilizes the design rule of incorporating at least 20% aluminum by mole fraction in the composition of at least the top subcell.

In some embodiments, the addition to identifying the composition and band gaps of the upper first, second and third solar subcells, a determination of the open circuit voltage, the short circuit density, the doping level, and the thickness of the subcell layers are considered.

In some embodiments, a consideration of the parameter E_{g}/q - V_{oc} is utilized in the identifying step.

In some embodiments, the solar cell efficiency measured at high temperature (70° C) is at least 24.4% for a predetermined time of fifteen years.

In some embodiments, the selection of the composition of the subcells and their band gaps is designed to provide a minimum, but not maximum, efficiency at the time of initial deployment (referred to as the beginning of life or BOL).

In some embodiments, the selection of the composition of the subcells and their band gaps maximizes the efficiency at a predetermined high temperature (in the range of 50 to 100 degrees Centigrade) in deployment in space at AM0 at a predetermined time after initial deployment, such predetermined time being between one and twenty-five years and referred to as the end-of-life (EOL), and not at the beginning of life (BOL).

In another aspect, the present disclosure provides a method of manufacturing a four junction solar cell comprising providing a germanium substrate; growing on the germanium substrate a lattice matched sequence of layers of semiconductor material using a metal organic chemical vapor disposition process to form a solar cell comprising a plurality of subcells including a third subcell disposed over and lattice matched to the germanium substrate, a second subcell disposed over and lattice matched to the third subcell and having a band gap in the range of approximately 1.65 to 1.8 eV and an upper first subcell disposed over and lattice matched to the second subcell and having a band gap in the range of 2.0 to 2.15 eV, such that the average band gap of all four subcells (i.e., the sum of the four band gaps of each subcell divided by four) is greater than 1.44 eV, and the lattice constant of each of the subcells is 5.653 Angstroms.

In another aspect, the present disclosure provides a method of fabricating a four junction solar cell comprising an upper first solar subcell composed of indium gallium aluminum phosphide and having a first band gap a second solar subcell adjacent to said first solar subcell including an emitter layer composed of indium gallium phosphide or aluminum gallium arsenide, and a base layer composed of aluminum gallium arsenide and having a second band gap smaller than the first band gap and being lattice matched with the upper first solar subcell a third solar subcell adjacent to said second solar subcell and composed of indium gallium arsenide and having a third band gap smaller than the second band gap and being lattice matched with the second solar subcell; and a fourth solar subcell adjacent to said third solar subcell and composed of germanium having a fourth band gap smaller than the third band gap; wherein the selection of the composition of the subcells and their band gaps maximizes the efficiency at high temperature (in the range of 50 to 100 degrees Centigrade) in deployment in space at a specific predetermined time after the initial deployment (referred to as the beginning of life or BOL), such predetermined time being referred to as the end-of-life (EOL), and being at least one year after the BOL, and does not maximize the efficiency at BOL.

In some embodiments, the fourth subcell is germanium.

In some embodiments, the fourth subcell is InGaAs, GaAsSb, InAsP, InAlAs, or SiGeSn, InGaAsN, InGaAsNSb, InGaAsNBi, InGaAsNSbBi, InGaSbN, InGaBiN, InGaSbBiN.

In some embodiments, the fourth or bottom solar subcell has a band gap of approximately 0.67 eV, the third solar subcell has a band gap of approximately 1.41 eV, the second solar subcell has a band gap in the range of approximately 1.65 to 1.8 eV and the upper first solar subcell has a band gap in the range of 2.0 to 2.2 eV.

In some embodiments, the second solar subcell has a band gap of approximately 1.73 eV and the upper first subcell has a band gap of approximately 2.10 eV.

In some embodiments the fourth or upper subcell is composed of a semiconductor compound including at least indium, aluminum and phosphorus; or the compound indium gallium aluminum phosphide;
the third solar subcell is composed of (i) an emitter layer composed of indium gallium phosphide or (aluminum) indium gallium arsenide, and a base layer composed of (aluminum) indium gallium arsenide; or (ii) semiconductor compound including at least indium, aluminum and phosphorus; the second solar cell is composed of indium gallium arsenide phosphide; and the first or bottom solar subcell is composed of geranium.

In some embodiments, there further comprises a distributed Bragg reflector (DBR) layer adjacent to and between the third and the fourth solar subcells and arranged so that light can enter and pass through the third solar subcell and at least a portion of which can be reflected back into the third solar subcell by the DBR layer.

In some embodiments, there further comprises a distributed Bragg reflector (DBR) layer adjacent to and between the second and the third solar subcells and arranged so that light can enter and pass through the through the third solar subcell and at least a portion of which can be reflected back into the third solar subcell by the DBR layer.

In some embodiments, the distributed Bragg reflector layer is composed of a plurality of alternating layers of lattice matched materials with discontinuities in their respective indices of refraction.

In some embodiments, the difference in refractive indices between alternating layers is maximized in order to minimize the number of periods required to achieve a given reflectivity, and the thickness and refractive index of each period determines the stop band and its limiting wavelength.

In some embodiments, the DBR layer includes a first DBR layer composed of a plurality of p type AlₓGa₁₋ₓAs layers, and a second DBR layer disposed over the first DBR layer and composed of a plurality of n or p type Al_{y}Ga_{1-y}As layers, where y is greater than x, 0 < x < 1, and 0 < y < 1.

In some embodiments, additional layer(s) may be added or deleted in the cell structure without departing from the scope of the present disclosure.

Some implementations of the present disclosure may incorporate or implement fewer of the aspects and features noted in the foregoing summaries.

Additional aspects, advantages, and novel features of the present disclosure will become apparent to those skilled in the art from this disclosure, including the following detailed description as well as by practice of the disclosure. While the disclosure is described below with reference to preferred embodiments, it should be understood that the disclosure is not limited thereto. Those of ordinary skill in the art having access to the teachings herein will recognize additional applications, modifications and embodiments in other fields, which are within the scope of the disclosure as disclosed and claimed herein and with respect to which the disclosure could be of utility.

### BRIEF DESCRIPTION OF THE DRAWINGS

The invention will be better and more fully appreciated by reference to the following detailed description when considered in conjunction with the accompanying drawings, wherein:
FIG. 1 is a graph representing the BOL value of the parameter E_{g}/q - V_{oc} at 28° C plotted against the band gap of certain binary materials defined along the x-axis;
FIG. 2 is a cross-sectional view of the solar cell of a four junction solar cell after several stages of fabrication including the deposition of certain semiconductor layers on the growth substrate up to the grid lines, according to a first embodiment;
FIG. 3 is a cross-sectional view of the solar cell of a four junction solar cell after several stages of fabrication including the deposition of certain semiconductor layers on the growth substrate up to the contact layer, according to the present disclosure; and
FIG. 4 is a graph of the doping profile in the base and emitter layers of a subcell in the solar cell according to the present disclosure.

### DESCRIPTION OF THE PREFERRED EMBODIMENT

Details of the present invention will now be described including exemplary aspects and embodiments thereof. Referring to the drawings and the following description, like reference numbers are used to identify like or functionally similar elements, and are intended to illustrate major features of exemplary embodiments in a highly simplified diagrammatic manner. Moreover, the drawings are not intended to depict every feature of the actual embodiment nor the relative dimensions of the depicted elements, and are not drawn to scale.

A variety of different features of multijunction solar cells (as well as inverted metamorphic multijunction solar cells) are disclosed in the related applications noted above. Some, many or all of such features may be included in the structures and processes associated with the lattice matched or "upright" solar cells of the present disclosure. However, more particularly, the present disclosure is directed to the fabrication of a multijunction lattice matched solar cell grown on a single growth substrate. More specifically, however, in some embodiments, the present disclosure relates to four junction solar cells with direct band gaps in the range of 2.0 to 2.15 eV (or higher) for the top subcell, and (i) 1.65 to 1.8 eV, and (ii) 1.41 eV for the middle subcells, and 0.6 to 0.8 eV indirect bandgaps, for the bottom subcell, respectively.

Another way of characterizing the present disclosure is that in some embodiments of a four junction cell, aluminum is added to the top subcell in an amount of greater than 20% by mole fraction, and to the middle subcells, so that the resulting average band gap of all four subcells (i.e., the sum of the four band gaps of each subcell divided by four) is greater than 1.44 eV, or optionally 1.35 eV.

Another way of characterizing the present disclosure is that in some embodiments of a four junction solar cell, the average band gap of all four subcells (i.e., the sum of the four band gaps of each subcell divided by 4) is greater than 1.35 eV, and each subcell has a lattice constant of 5.653 Angstroms.

In some embodiments, the fourth subcell is germanium, while in other embodiments the fourth subcell is InGaAs, GaAsSb, InAsP, InAlAs, or SiGeSn, InGaAsN, InGaAsNSb, InGaAsNBi, InGaAsNSbBi, InGaSbN, InGaBiN, InGaSbBiN or other III-V or II-VI compound semiconductor material.

Another descriptive aspect of the present disclosure is to characterize the fourth subcell as having a direct band gap of greater than 0.75 eV.

The indirect band gap of germanium at room temperature is about 0.67 eV, while the direct band gap of germanium at room temperature is 0.8 eV. Those skilled in the art will normally refer to the "band gap" of germanium as 0.67 eV, since it is lower than the direct band gap value of 0.8 eV.

The recitation that "the fourth subcell has a direct band gap of greater than 0.75 eV" is therefore expressly meant to include germanium as a possible semiconductor for the fourth subcell, although other semiconductor material can be used as well.

More specifically, the present disclosure intends to provide a relatively simple and reproducible technique that does not employ inverted processing associated with inverted metamorphic multijunction solar cells, and is suitable for use in a high volume production environment in which various semiconductor layers are grown on a growth substrate in an MOCVD reactor, and subsequent processing steps are defined and selected to minimize any physical damage to the quality of the deposited layers, thereby ensuring a relatively high yield of operable solar cells meeting specifications at the conclusion of the fabrication processes.

The conventional wisdom for many years has been that in a monolithic multijunction tandem solar cell , "... the desired optical transparency and current conductivity between the top and bottom cells... would be best achieved by lattice matching the top cell material to the bottom cell material. Mismatches in the lattice constants create defects or dislocations in the crystal lattice where recombination centers can occur to cause the loss of photogenerated minority carriers, thus significantly degrading the photovoltaic quality of the device. More specifically, such effects will decrease the open circuit voltage (V_{oc}), short circuit current (J_{sc}), and fill factor (FF), which represents the relationship or balance between current and voltage for effective output" (Jerry M. Olson, U.S. Patent No. 4,667,059, "Current and Lattice Matched Tandem Solar Cell").

As progress has been made toward higher efficiency multijunction solar cells with four or more subcells, nevertheless, "it is conventionally assumed that substantially lattice-matched designs are desirable because they have proven reliability and because they use less semiconductor material than metamorphic solar cells, which require relatively thick buffer layers to accommodate differences in the lattice constants of the various materials" (Rebecca Elizabeth Jones - Albertus et al., U.S. Patent No. 8,962,993).

Even more recently "...current output in each subcell must be the same for optimum efficiency in the series - connected configuration" (Richard R. King et al., U.S. Patent No. 9,099,595).

The present disclosure provides an unconventional four junction design (with three grown lattice matched subcells, which are lattice mismatched to the Ge substrate) that leads to significant performance improvement over that of traditional three junction solar cell on Ge despite the substantial current mismatch present between the top three junctions and the bottom Ge junction. This performance gain is especially realized at high temperature and after high exposure to space radiation by the proposal of incorporating high band gap semiconductors that are inherently more resistant to radiation and temperature.

One aspect of the present disclosure relates to the use of aluminum in the active layers of the upper subcells in a multijunction solar cell. The effects of increasing amounts of aluminum as a constituent element in an active layer of a subcell affects the photovoltaic device performance. One measure of the "quality" or "goodness" of a solar cell junction is the difference between the band gap of the semiconductor material in that subcell or junction and the V_{oc}, or open circuit voltage, of that same junction. The smaller the difference, the higher the V_{oc} of the solar cell junction relative to the band gap, and the better the performance of the device. V_{oc} is very sensitive to semiconductor material quality, so the smaller the E_{g}/q - V_{oc} of a device, the higher the quality of the material in that device. There is a theoretical limit to this difference, known as the Shockley-Queisser limit. That is the best that a solar cell junction can be under a given concentration of light at a given temperature.

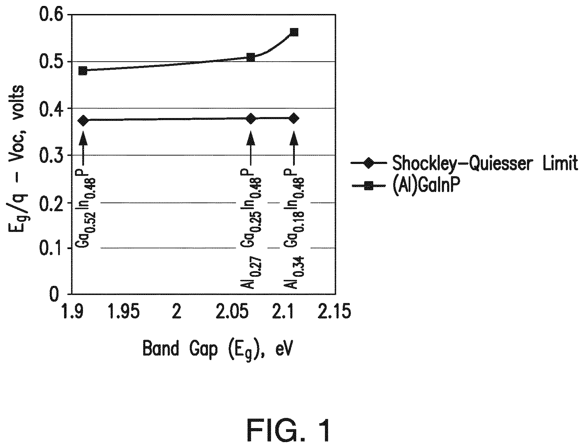

The experimental data obtained for single junction (Al)GaInP solar cells indicates that increasing the Al content of the junction leads to a larger V_{oc} - E_{g}/q difference, indicating that the material quality of the junction decreases with increasing Al content. Figure 1 shows this effect. The three compositions cited in the Figure are all lattice matched to GaAs, but have differing Al composition. Adding Al increases the band gap of the junction, but in so doing also increases V_{oc} - E_{g}/q. Hence, we draw the conclusion that adding Al to a semiconductor material degrades that material such that a solar cell device made out of that material does not perform relatively as well as a junction with less Al.

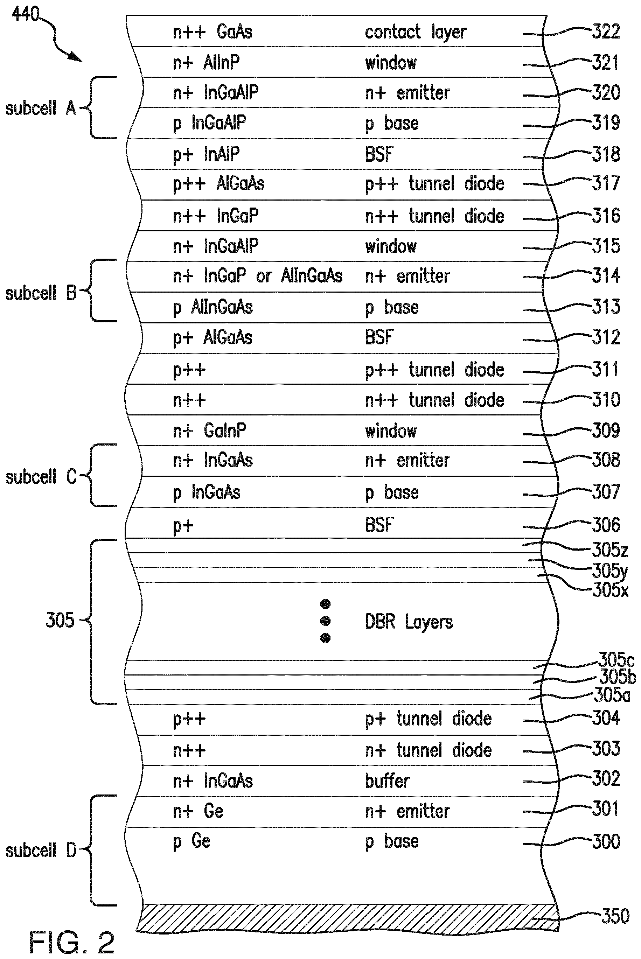

FIG. 2 illustrates a particular example of a multijunction solar cell device 440 according to the present disclosure.

As shown in the illustrated example of FIG. 2, the bottom subcell D includes a substrate 300 formed of p-type germanium ("Ge") which also serves as a base layer. A back metal contact pad 350 formed on the bottom of base layer 300 provides electrical contact to the multijunction solar cell 440. The bottom subcell D, further includes, for example, a highly doped n-type Ge emitter layer 301, and an n-type indium gallium arsenide ("InGaAs") nucleation layer 302. The nucleation layer is deposited over the base layer, and the emitter layer is formed in the substrate by diffusion of deposits into the Ge substrate, thereby forming the n-type Ge layer 301. Heavily doped p-type aluminum gallium arsenide ("AlGaAs") and heavily doped n-type gallium arsenide ("GaAs") tunneling junction layers 304, 303 may be deposited over the nucleation layer to provide a low resistance pathway between the bottom and middle subcells.

Distributed Bragg reflector (DBR) layers 305 are then grown adjacent to and between the tunnel diode 303, 304 of the bottom subcell D and the third solar subcell C. The DBR layers 305 are arranged so that light can enter and pass through the third solar subcell C and at least a portion of which can be reflected back into the third solar subcell C by the DBR layers 305. In the embodiment depicted in FIG. 2, the distributed Bragg reflector (DBR) layers 305 are specifically located between the third solar subcell C and tunnel diode layers 304, 303; in other embodiments, the distributed Bragg reflector (DBR) layers may be located between tunnel diode layers 304/303 and subcell D.

For some embodiments, distributed Bragg reflector (DBR) layers 305 can be composed of a plurality of alternating layers 305a through 305z of lattice matched materials with discontinuities in their respective indices of refraction. For certain embodiments, the difference in refractive indices between alternating layers is maximized in order to minimize the number of periods required to achieve a given reflectivity, and the thickness and refractive index of each period determines the stop band and its limiting wavelength.

For some embodiments, distributed Bragg reflector (DBR) layers 305a through 305z includes a first DBR layer composed of a plurality of p type AlₓGa₁₋ₓAs layers, and a second DBR layer disposed over the first DBR layer and composed of a plurality of n or p type Al_{y}Ga_{1-y}As layers, where and y is greater than x.

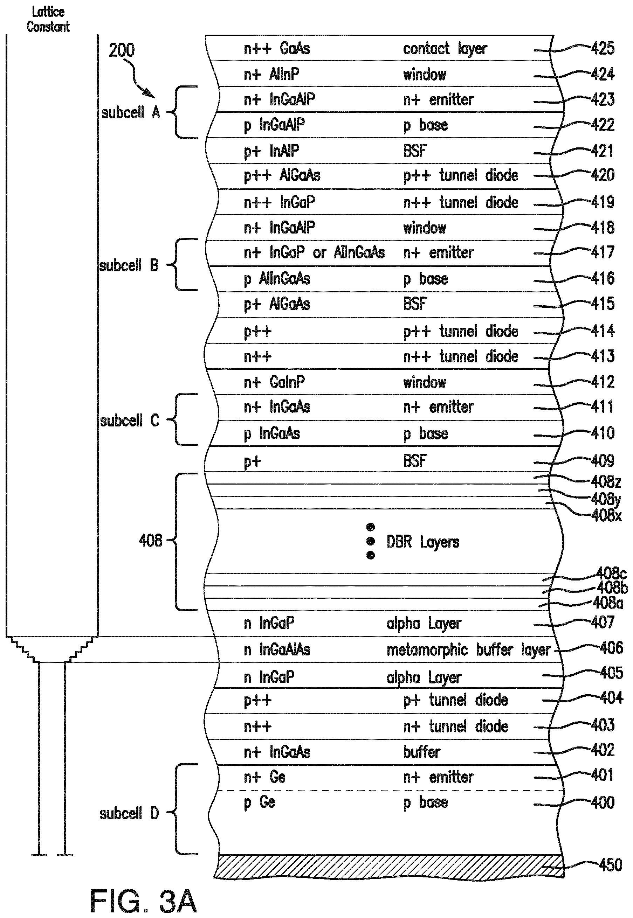

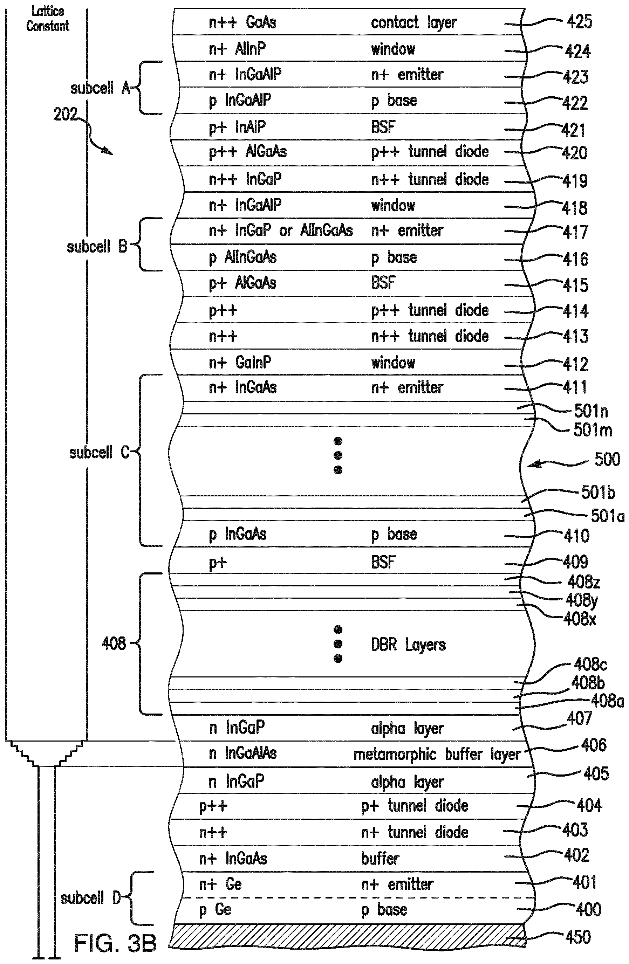

In the illustrated example of FIG. 3, the subcell C includes a highly doped p-type aluminum gallium arsenide ("AlGaAs") back surface field ("BSF") layer 306, a p-type InGaAs base layer 307, a highly doped n-type indium gallium arsenide ("InGaAs") emitter layer 308 and a highly doped n-type indium aluminum phosphide ("AlInP₂") or indium gallium phosphide ("GaInP") window layer 309. The InGaAs base layer 307 of the subcell C can include, for example, approximately 1.5% In. Other compositions may be used as well. The base layer 307 is formed over the BSF layer 306 after the BSF layer is deposited over the DBR layers 305.

The window layer 309 is deposited on the emitter layer 308 of the subcell C. The window layer 309 in the subcell C also helps reduce the recombination loss and improves passivation of the cell surface of the underlying junctions. Before depositing the layers of the subcell B, heavily doped n-type InGaP and p-type AlGaAs (or other suitable compositions) tunneling junction layers 310, 311 may be deposited over the subcell C.

The middle subcell B includes a highly doped p-type aluminum gallium arsenide ("AlGaAs") back surface field ("BSF") layer 312, a p-type AlGaAs base layer 313, a highly doped n-type indium gallium phosphide ("InGaP₂") or AlGaAs layer 314 and a highly doped n-type indium gallium aluminum phosphide ("AlGaAlP") window layer 315. The InGaP emitter layer 314 of the subcell B can include, for example, approximately 50% In. Other compositions may be used as well.

Before depositing the layers of the top cell A, heavily doped n-type InGaP and p-type AlGaAs tunneling junction layers 316, 317 may be deposited over the subcell B.

In the illustrated example, the top subcell A includes a highly doped p-type indium aluminum phosphide ("InAlP₂") BSF layer 318, a p-type InGaAlP base layer 319, a highly doped n-type InGaAlP emitter layer 320 and a highly doped n-type InAlP₂ window layer 321. The base layer 319 of the top subcell A is deposited over the BSF layer 318 after the BSF layer 318 is formed.

After the cap or contact layer 322 is deposited, the grid lines are formed via evaporation and lithographically patterned and deposited over the cap or contact layer 322.

Turning to a second embodiment of the multijunction solar cell device of the present disclosure, FIG. 3 is a cross-sectional view of an embodiment of a four junction solar cell 200 after several stages of fabrication including the growth of certain semiconductor layers on the growth substrate up to the contact layer 425, with various subcells being similar to the structure described and depicted in FIG. 2. This embodiment corresponds to Fig. 2 in related U.S. Patent Application Serial No. 15/681,144, filed August 18, 2017, now U.S. Patent No. 10,700,230.

As shown in the illustrated example of FIG. 3A, the bottom subcell D includes a substrate 400 formed of p-type germanium ("Ge") which also serves as a base layer. A back metal contact pad 450 formed on the bottom of base layer 400 provides electrical contact to the multijunction solar cell 500. The bottom subcell D, further includes, for example, a highly doped n-type Ge emitter layer 401, and an n-type indium gallium arsenide ("InGaAs") nucleation layer 402. The nucleation layer is deposited over the base layer, and the emitter layer is formed in the substrate by diffusion of deposits into the Ge substrate, thereby forming the n-type Ge layer 401. Heavily doped p-type aluminum gallium arsenide ("AlGaAs") and heavily doped n-type gallium arsenide ("GaAs") tunneling junction layers 403, 404 may be deposited over the nucleation layer to provide a low resistance pathway between the bottom and middle subcells.

A first alpha layer 405, preferably composed of n-type AlGaInAsP, is deposited over the tunnel diode 403/404, to a thickness of from 0.25 to about 1.0 micron. Such an alpha layer is intended to prevent threading dislocations from propagating, either opposite to the direction of growth into the bottom subcell D, or in the direction of growth into the subcell C, and is more particularly described in U.S. Patent Application Pub. No. 2009/0078309 A1 (Cornfeld et al.).

A metamorphic layer (or graded interlayer) 406 is deposited over the alpha layer 405 using a surfactant. Layer 406 is preferably a compositionally step-graded series of InGaAlAs layers, preferably with monotonically changing lattice constant, so as to achieve a gradual transition in lattice constant in the semiconductor structure from subcell D to subcell C while minimizing threading dislocations from occurring. The band gap of layer 406 is constant throughout its thickness, preferably approximately equal to 1.22 to 1.34 eV, or otherwise consistent with a value slightly greater than the band gap of the middle subcell C. One embodiment of the graded interlayer may also be expressed as being composed of InₓGa₁₋ₓAs, with x and y selected such that the band gap of the interlayer remains constant at approximately 1.22 to 1.34 eV or other appropriate band gap.

In the surfactant assisted growth of the metamorphic layer 406, a suitable chemical element is introduced into the reactor during the growth of layer 406 to improve the surface characteristics of the layer. In the preferred embodiment, such element may be a dopant or donor atom such as selenium (Se) or tellurium (Te). Small amounts of Se or Te are therefore incorporated in the metamorphic layer 406, and remain in the finished solar cell. Although Se or Te are the preferred n-type dopant atoms, other non-isoelectronic surfactants may be used as well.

Surfactant assisted growth results in a much smoother or planarized surface. Since the surface topography affects the bulk properties of the semiconductor material as it grows and the layer becomes thicker, the use of the surfactants minimizes threading dislocations in the active regions, and therefore improves overall solar cell efficiency.

As an alternative to the use of non-isoelectronic one may use an isoelectronic surfactant. The term "isoelectronic" refers to surfactants such as antimony (Sb) or bismuth (Bi), since such elements have the same number of valence electrons as the P atom of InGaP, or the As atom in InGaAlAs, in the metamorphic buffer layer. Such Sb or Bi surfactants will not typically be incorporated into the metamorphic layer 406.

In one embodiment of the present disclosure, the layer 406 is composed of a plurality of layers of InGaAs, with monotonically changing lattice constant, each layer having the same band gap, approximately in the range of 1.22 to 1.34 eV. In some embodiments, the constant band gap is in the range of 1.27 to 1.31 eV. In some embodiments, the constant band gap is in the range of 1.28 to 1.29 eV.

The advantage of utilizing a constant bandgap material such as InGaAs is that arsenide-based semiconductor material is much easier to process in standard commercial MOCVD reactors.

Although the preferred embodiment of the present disclosure utilizes a plurality of layers of InGaAs for the metamorphic layer 406 for reasons of manufacturability and radiation transparency, other embodiments of the present disclosure may utilize different material systems to achieve a change in lattice constant from subcell C to subcell D. Other embodiments of the present disclosure may utilize continuously graded, as opposed to step graded, materials. More generally, the graded interlayer may be composed of any of the As, P, N, Sb based III - V compound semiconductors subject to the constraints of having the in-plane lattice parameter greater than or equal to that of the second solar cell and less than or equal to that of the third solar cell, and having a bandgap energy greater than that of the second solar cell.

A second alpha layer 407, preferably composed of n+ type GaInP, is deposited over metamorphic buffer layer 406, to a thickness of from 0.25 to about 1.0 micron. Such an alpha layer is intended to prevent threading dislocations from propagating, either opposite to the direction of growth into the subcell D, or in the direction of growth into the subcell C, and is more particularly described in U.S. Patent Application Pub. No. 2009/0078309 A1 (Cornfeld et al.).

Distributed Bragg reflector (DBR) layers 408 are then grown adjacent to and between the alpha layer 407 and the third solar subcell C. The DBR layers 408 are arranged so that light can enter and pass through the third solar subcell C and at least a portion of which can be reflected back into the third solar subcell C by the DBR layers 408. In the embodiment depicted in FIG. 3A, the distributed Bragg reflector (DBR) layers 408 are specifically located between the third solar subcell C and second alpha layers 407; in other embodiments, the distributed Bragg reflector (DBR) layers may be located between first alpha layer 405 and tunnel diode layers 403/404.

For some embodiments, distributed Bragg reflector (DBR) layers 408 can be composed of a plurality of alternating layers 408a through 408z of lattice matched materials with discontinuities in their respective indices of refraction. For certain embodiments, the difference in refractive indices between alternating layers is maximized in order to minimize the number of periods required to achieve a given reflectivity, and the thickness and refractive index of each period determines the stop band and its limiting wavelength.

For some embodiments, distributed Bragg reflector (DBR) layers 408a through 408z includes a first DBR layer composed of a plurality of p type AlₓGa₁₋ₓAs layers, and a second DBR layer disposed over the first DBR layer and composed of a plurality of p type Al_{y}Ga_{1-y}As layers, where y is greater than x.

In the illustrated example of FIG. 3A, the subcell C includes a highly doped p-type aluminum gallium arsenide ("AlGaAs") back surface field ("BSF") layer 409, a p-type InGaAs base layer 410, a highly doped n-type indium gallium phosphide ("InGaP2") emitter layer 411 and a highly doped n-type indium aluminum phosphide ("AlInP2") window layer 412. The InGaAs base layer 410 of the subcell C can include, for example, approximately 1.5% In. Other compositions may be used as well. The base layer 410 is formed over the BSF layer 409 after the BSF layer is deposited over the DBR layers 408a through 408z.

The window layer 412 is deposited on the emitter layer 411 of the subcell C. The window layer 412 in the subcell C also helps reduce the recombination loss and improves passivation of the cell surface of the underlying junctions. Before depositing the layers of the subcell B, heavily doped n-type InGaP and p-type AlGaAs (or other suitable compositions) tunneling junction layers 413, 414 may be deposited over the subcell C.

The middle subcell B includes a highly doped p-type aluminum gallium arsenide ("AlGaAs") back surface field ("BSF") layer 415, a p-type AlGaAs base layer 416, a highly doped n-type indium gallium phosphide ("InGaP2") or AlGaAs layer 417 and a highly doped n-type indium gallium aluminum phosphide ("AlGaAlP") window layer 418. The InGaP emitter layer 417 of the subcell B can include, for example, approximately 50% In. Other compositions may be used as well.

Before depositing the layers of the top cell A, heavily doped n-type InGaP and p-type AlGaAs tunneling junction layers 419, 420 may be deposited over the subcell B.

In the illustrated example, the top subcell A includes a highly doped p-type indium aluminum phosphide ("InAlP") BSF layer 421, a p-type InGaAlP base layer 422, a highly doped n-type InGaAlP emitter layer 423 and a highly doped n-type InAlP2 window layer 424. The base layer 422 of the top subcell A is deposited over the BSF layer 421 after the BSF layer 421 is formed over the tunneling junction layers 419, 420 of the subcell B. The window layer 424 is deposited over the emitter layer 423 of the top subcell A after the emitter layer 423 is formed over the base layer 422.

A cap or contact layer 425 may be deposited and patterned into separate contact regions over the window layer 424 of the top subcell A. The cap or contact layer 425 serves as an electrical contact from the top subcell A to metal grid layer (not shown). The doped cap or contact layer 425 can be a semiconductor layer such as, for example, a GaAs or InGaAs layer.

After the cap or contact layer 425 is deposited, the grid lines are formed via evaporation and lithographically patterned and deposited over the cap or contact layer 425.

In some embodiments, at least the base of at least one of the first, second or third solar subcells has a graded doping, i.e., the level of doping varies from one surface to the other throughout the thickness of the base layer. In some embodiments, the gradation in doping is exponential. In some embodiments, the gradation in doping is incremental and monotonic.

In some embodiments, the emitter of at least one of the first, second or third solar subcells also has a graded doping, i.e., the level of doping varies from one surface to the other throughout the thickness of the emitter layer. In some embodiments, the gradation in doping is linear or monotonically decreasing.

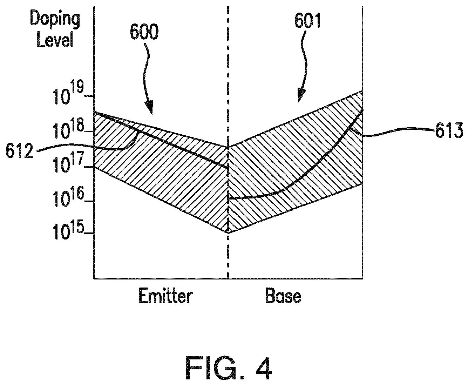

As a specific example, the doping profile of the emitter and base layers may be illustrated in Figure 4, which depicts the amount of doping in the emitter region and the base region of a subcell. N-type dopants include silicon, selenium, sulfur, germanium or tin. P-type dopants include silicon, zinc, chromium, or germanium.

In the example of Figure 4, in some embodiments, one or more of the subcells have a base region having a gradation in doping that increases from a value in the range of 1 × 10¹⁵ to 1 × 10¹⁸ free carriers per cubic centimeter adjacent the p-n junction to a value in the range of 1 × 10¹⁶ to 4 × 10¹⁸ free carriers per cubic centimeter adjacent to the adjoining layer at the rear of the base, and an emitter region having a gradation in doping that decreases from a value in the range of approximately 5 × 10¹⁸ to × 10¹⁷ free carriers per cubic centimeter in the region immediately.

The present disclosure provides a multijunction solar cell that follows a design rule that one should incorporate as many high band gap subcells as possible to achieve the goal to increase the efficiency at high temperature EOL. For example, high band gap subcells may retain a greater percentage of cell voltage as temperature increases, thereby offering lower power loss as temperature increases. As a result, both HT-BOL and HT-EOL performance of the exemplary multijunction solar cell, according to the present disclosure, may be expected to be greater than traditional cells.

In view of different satellite and space vehicle requirements in terms of operating environmental temperature, radiation exposure, and operational life, a range of subcell designs using the design principles of the present disclosure may be provided satisfying specific defined customer and mission requirements, and several illustrative embodiments are set forth hereunder, along with the computation of their efficiency at the end-of-life for comparison purposes. As described in greater detail below, solar cell performance after radiation exposure is experimentally measured using 1 MeV electron fluence per square centimeter (abbreviated in the text that follows as e/cm²), so that a comparison can be made between the current commercial devices and embodiments of solar cells discussed in the present disclosure.

As an example of different mission requirements, a low earth orbit (LEO) satellite will typically experience radiation of protons equivalent to an electron fluence per square centimeter in the range of 1 × 10¹² e/cm² to 2 × 10¹⁴ e/cm² (hereinafter may be written as "2E10 e/cm² or 2E14") over a five year lifetime. A geosynchronous earth orbit (GEO) satellite will typically experience radiation in the range of 5 × 10¹⁴ e/cm² to 1 × 10¹⁵ e/cm² over a fifteen year lifetime.

As a baseline comparison, the cell efficiency (%) measured at room temperature (RT) 28° C and high temperature (HT) 70° C, at beginning of life (BOL) and end of life (EOL), for a standard three junction commercial solar cell (the ZTJ of SolAero Technologies Corp., of Albuquerque, New Mexico), is as follows:

| Condition | Efficiency | |
|---|---|---|
| BOL 28° C | 29.1% | |
| BOL 70° C | 26.4% | |
| EOL 70° C | 23.4% | after 5E14 e/cm² radiation |
| EOL 70°C | 22.0% | after 1E15 e/cm² radiation |

The J_{sc} of the upper two subcells at EOL under 1E15 conditions is 17.2 mA, and the ratio of the upper junction J_{sc} to the bottom subcell J_{sc} is 139%.

The simplest manner to express the different embodiments of the present disclosure and their efficiency compared to that of the standard solar cell noted above is to list the embodiments with the specification of the composition of each successive subcell and their respective band gap, and then the computed efficiency.

Thus, for a four junction solar cell configured and described in the parent application and the present disclosure, four embodiments and their corresponding efficiency data at the end-of-life (EOL) is as follows:

| Embodiment 1 | Band Gap | Composition |
|---|---|---|
| Subcell A | 2.1 | AlInGaP |
| Subcell B | 1.73 | InGaP or AlInGaAs/AlInGaAs or InGaAs |
| Subcell C | 1.41 | (In)GaAs |
| Subcell D | 0.67 | Ge |

Efficiency at 70° C after 1E15 e/cm² radiation: 23.4%

| Embodiment 2 | Band Gap | Composition |
|---|---|---|
| Subcell A | 2.1 | AlInGaP |
| Subcell B | 1.67 | InGaP or AlInGaAs/AlInGaAs or InGaAs |
| Subcell C | 1.34 | InGaAs |
| Subcell D | 0.67 | Ge |

Efficiency at 70° C after 1E15 e/cm² radiation: 23.8%

| Embodiment 3 | Band Gap | Composition |
|---|---|---|
| Subcell A | 2.5 | AlInGaP |
| Subcell B | 1.63 | InGaP or AlInGaAs/AlInGaAs or InGaAs |
| Subcell C | 1.30 | (In)GaAs |
| Subcell D | 0.67 | Ge |

Efficiency at 70° C after 1E15 e/cm² radiation: 24.2%

| Embodiment 4 | Band Gap | Composition |
|---|---|---|
| Subcell A | 2.02 | AlInGaP |
| Subcell B | 1.58 | InGaP or AlGaAs/AlInGaAs or InGaAs |
| Subcell C | 1.25 | (In)GaAs |
| Subcell D | 0.67 | Ge |

Efficiency at 70° C after 1E15 e/cm² radiation: 25.2%

For a five junction solar cell configured and described in the parent application and the present disclosure, some embodiments and corresponding efficiency data at the end-of-life (EOL) computed at 28° C is as follows:

| Embodiment 5 | Band Gap | | Composition |
|---|---|---|---|
| Subcell A | 1.98 | | AlInGaP |
| Subcell B | 1.78 | | InGaP or AllnGaAs |
| Subcell C | 1.48 | | A1InGaAs |
| Subcell D | 1.2 | | InGaAs |
| Subcell E | 0.67 | | Ge |
| | | Efficiency: 27.9% | |

| Embodiment 6 | Band Gap | | Composition |
|---|---|---|---|
| Subcell A | 1.95 | | AlInGaP |
| Subcell B | 1.69 | | InGaP or AlInGaAs |
| Subcell C | 1.38 | | A1InGaAs |
| Subcell D | 1.10 | | InGaAs |
| Subcell E | 0.67 | | Ge |
| | | Efficiency: 28.4% | |

The new solar cell has a higher cell efficiency than the standard commercial solar cell (ZTJ) at BOL at 70° C. However, the solar cell described in the present disclosure in the first embodiment exhibits substantially improved cell efficiency (%) over the standard commercial solar cell (ZTJ) at 1 MeV electron equivalent fluence of 5 × 10¹⁴ e/cm², and dramatically improved cell efficiency (%) over the standard commercial solar cell (ZTJ) at 1 MeV electron equivalent fluence of 1 × 10¹⁵ e/cm².

The wide range of electron and proton energies present in the space environment necessitates a method of describing the effects of various types of radiation in terms of a radiation environment which can be produced under laboratory conditions. The methods for estimating solar cell degradation in space are based on the techniques described by Brown et al. [Brown, W. L., J. D. Gabbe, and W. Rosenzweig, Results of the Telstar Radiation Experiments, Bell System Technical J., 42, 1505, 1963] and Tada [Tada, H. Y., J.R. Carter, Jr., B.E. Anspaugh, and R. G. Downing, Solar Cell Radiation Handbook, Third Edition, JPL Publication 82-69, 1982]. In summary, the omnidirectional space radiation is converted to a damage equivalent unidirectional fluence at a normalised energy and in terms of a specific radiation particle. This equivalent fluence will produce the same damage as that produced by omnidirectional space radiation considered when the relative damage coefficient (RDC) is properly defined to allow the conversion. The relative damage coefficients (RDCs) of a particular solar cell structure are measured a priori under many energy and fluence levels in addition to different coverglass thickness values. When the equivalent fluence is determined for a given space environment, the parameter degradation can be evaluated in the laboratory by irradiating the solar cell with the calculated fluence level of unidirectional normally incident flux. The equivalent fluence is normally expressed in terms of 1 MeV electrons or 10 MeV protons.

The software package Spenvis (www.spenvis.oma.be) is used to calculate the specific electron and proton fluence that a solar cell is exposed to during a specific satellite mission as defined by the duration, altitude, azimuth, etc. Spenvis employs the EQFLUX program, developed by the Jet Propulsion Laboratory (JPL) to calculate 1 MeV and 10 MeV damage equivalent electron and proton fluences, respectively, for exposure to the fluences predicted by the trapped radiation and solar proton models for a specified mission environment duration. The conversion to damage equivalent fluences is based on the relative damage coefficients determined for multijunction cells [Marvin, D.C., Assessment of Multijunction Solar Cell Performance in Radiation Environments, Aerospace Report No. TOR-2000 (1210)-1, 2000]. A widely accepted total mission equivalent fluence for a geosynchronous satellite mission of 15 year duration is 1MeV 1×10¹⁵ electrons/cm².

The exemplary solar cell described herein may require the use of aluminum in the semiconductor composition of each of the top two subcells. Aluminum incorporation is widely known in the III-V compound semiconductor industry to degrade BOL subcell performance due to deep level donor defects, higher doping compensation, shorter minority carrier lifetimes, and lower cell voltage and an increased BOL E_{g}/q - V_{oc} metric. In short, increased BOL E_{g}/q - V_{oc} may be the most problematic shortcoming of aluminum containing subcells; the other limitations can be mitigated by modifying the doping schedule or thinning base thicknesses.

It will be understood that each of the elements described above, or two or more together, also may find a useful application in other types of structures or constructions differing from the types of structures or constructions described above.

## Claims

1. A multijunction solar cell comprising:
a germanium growth substrate;
a first solar subcell formed over or in the growth substrate;
a graded interlayer formed over the growth substrate;
a second solar subcell disposed over a lattice mismatched with respect to the growth substrate and having a band gap in the range of 1.2 to 1.35 eV;
a third solar subcell disposed over the second solar subcell and having a band gap in the range of approximately 1.61 to 1.8 eV;
an upper or fourth solar subcell disposed over the third subcell and having an aluminum content in excess of 20% by mole fraction, and having a band gap in the range of 1.95 to 2.20 eV;
wherein the graded interlayer is compositionally graded to lattice match the growth substrate on one side and the second solar subcell on the other side, and is composed of any of the As, P, N, Sb based III-V compound semiconductors subject to the constraints of having the in-plane lattice parameter throughout its thickness being greater than or equal to that of the growth substrate; and
wherein the selection of the composition of the subcells and their band gaps maximizes the efficiency at high temperature in the range of 50 to 100 degrees Centigrade in deployment in space at a specific predetermined time after initial deployment referred to as the beginning of life or BOL, such predetermined time being referred to as the end-of-life, EOL, and being at least five years after the BOL, such selection being designed not to maximize the efficiency at BOL but to increase the solar cell efficiency at the EOL while disregarding the solar cell efficiency achieved at the BOL, such that the solar cell efficiency designed at the BOL is less than the solar cell efficiency at the BOL that would be achieved if the selection were designed to maximize the solar cell efficiency at the BOL.

2. A multijunction solar cell as defined in claim 1, wherein:
the first solar subcell is composed of germanium;
the second solar subcell is composed of indium gallium arsenide;
the third solar subcell is composed of a semiconductor compound including at least indium, gallium, arsenic, and phosphorus, or the compound (aluminum) indium gallium arsenide;
the fourth or upper subcell is composed of a semiconductor compound including at least aluminum, indium and phosphorus, or the compound indium gallium phosphide; and
the graded interlayer is composed of (InₓGa₁₋ₓ)_{y}Al_{1-y}As with 0 < x < 1, 0 < y < 1.

3. A multijunction solar cell as defined in claim 1 or 2, further comprising a tunnel diode is grown over the growth substrate, with the graded interlayer grown over the tunnel diode.

4. A multijunction solar cell as defined in claim 1or 2, wherein the graded interlayer is grown directly over the growth substrate, and further comprising a tunnel diode grown over the graded interlayer.

5. A multijunction solar cell as defined in any of the preceding claims, further comprising:
a distributed Bragg reflector (DBR) structure disposed between the second solar subcell and the first solar subcell and composed of a plurality of alternating layers of lattice mismatched materials with discontinuities in their respective indices of refraction and arranged so that light can enter and pass through the second solar subcell and at least a portion of which light having a first spectral width wavelength range including the band gap of the second solar subcell can be reflected back into the second solar subcell by the DBR structure, and a second portion of which light in a second spectral width wavelength range corresponding to longer wavelengths than the first spectral width wavelength range can be transmitted through the DBR structure to the first solar subcells, disposed beneath the DBR structure, and wherein the difference in refractive indices between the alternating layers in the DBR structure is maximized in order to minimize the number of periods required to achieve a given reflectivity, and the thickness and refractive index of each period of the DBR structure determines the stop, its limiting wavelength, and wherein the DBR structure includes a first DBR sublayer composed of a plurality of n type or p type Alₓ(In)Ga₁₋ₓAs layers, and a second DBR sublayer disposed over the first DBR sublayer and composed of a plurality of n type or p type Al_{y}(In)Ga_{1-y}As layers, where 0 < x <1, 0 < y < 1, and y is greater than x and (In) represents an amount of indium so that the DBR layers are lattice matched to the first solar subcell.

6. A multijunction solar cell as defined in any of the preceding claims, wherein the third solar subcell has a band gap of approximately 1.73 eV and the upper or fourth subcell has a band gap of approximately 2.10 eV.

7. A multijunction solar cell as defined in any of the preceding claims, wherein the selection of the composition of the subcells is based upon a determination of the amount of radiation at a predetermined time being 1 MeV electron equivalent fluence of 1 × 10¹⁵ electrons/cm².

8. A multijunction solar cell as defined in any of the preceding claims, wherein the selection of the composition of the subcells and their band gaps is based upon a determination of the amount of radiation at a predetermined time under 1 MeV electron equivalent fluence between 5 × 10¹⁴ electrons/cm² and 5 × 10¹⁵ electrons/cm².

9. A multijunction solar cell as defined in any of the preceding claims, wherein the selection of the composition of the subcell and their band gaps of the second, third and upper on fourth solar subcell is performed by an analysis of test results by independently incrementally adjusting one or more of the interdependent variables including composition of a solar subcell layer, thickness of the solar subcell layer, doping of the solar subcell layer, and doping profile of the solar subcell layer.

10. A multijunction solar cell as defined in any of the preceding claims, wherein the composition and the band gaps of the second, third and upper nor fourth solar subcells that maximizes the efficiency of the solar cell at that predetermined time is identified by execution of a computer program that simulates the effect of radiation on the first, second and third solar subcells.

11. A multijunction solar cell as defined in any of the preceding claims, wherein the band gap of the graded interlayer is in the range of 1.22 to 1.54 eV throughout its thickness.

12. A multijunction solar cell as defined in any of the preceding claims, wherein at least one of the sublayers of the graded interlayer has a larger lattice constant than the adjacent semiconductor layer that is disposed above the graded interlayer.

13. A multijunction solar cell as defined in any of the preceding claims, wherein the difference in lattice constant between the adjacent third and upper or fourth solar subcells is in the range of 0.1 to 0.2 Angstroms.

14. A multijunction solar cell as defined in any of claims 4-13 further comprising an inactive majority carrier layer, such as a window, BSF, or tunnel diode layer, disposed over the second or third solar subcell and having a lattice constant that is greater than that of the first solar subcell so that the tunnel diode layers disposed over the graded interlayer are strained in tension.

15. A method of fabricating a four junction solar cell for deployment in space in AMO spectra in a specific earth orbit **characterized by** a predetermined temperature and radiation environment comprising:
providing a defined predetermined time and defined temperature in the range of 40° to 100° Centigrade after initial deployment, such time being at least one year and in the range of one to twenty-five years;
determining the amount of radiation experienced by the solar cell after deployment at the predetermined time in the specific earth orbit after deployment;
simulating the effect of such radiation and temperature on a plurality of first, second, third and upper or fourth solar subcell candidates for implementation by a computer program; and
identifying the composition and band gaps of the second, third and or fourth solar subcells that maximizes the efficiency of the solar cell at that predetermined time so that the selection of the composition of the solar subcells and their band gaps maximizes the efficiency at high temperature in the range of 50 to 100 degrees Centigrade in deployment in space at a specific predetermined time after initial deployment or the beginning of life or BOL, such predetermined time being referred to as the end-of-life, EOL, and being at least five years after the BOL, such selection being designed not to maximize the efficiency at BOL but to increase the solar cell efficiency at the EOL while disregarding the solar cell efficiency achieved at the BOL, such that the solar cell efficiency designed at the BOL is less than the solar cell efficiency at the BOL that would be achieved if the selection were designed to maximize the solar cell efficiency at the BOL.
